# EUROPEAN PATENT APPLICATION

(11) **EP 1 369 506 A1**
(43) Date of publication of application: **10.12.2003**
(21) Application number: 03011066.2
(22) Date of filing: 20.05.2003
(51) Int. Cl.: C30B 11/12, C30B 29/60

(54) **Method of making photonic crystal**

(30) Priority: 28.05.2002 JP 2002153860
(71) Applicant: JAPAN AVIATION ELECTRONICS INDUSTRY, LIMITED, Shibuya-ku, Tokyo 150-0043 (JP)
(72) Inventor: Mori, Keiichi, Japan Aviation Electronics, Shibuya-ku, Tokyo 150-0043 (JP)
(74) Representative: Hoffmann, Eckart, Dipl.-Ing.

(57) **Abstract**

A periodic pattern of thin-film metal (gold) island regions 25 is formed over the entire surface area of a (111) single-crystal silicon layer overlying a layer of a material (silicon dioxide) 22 different in refractive index from silicon, and silicon monocrystalline rods 26 are grown beneath the thin-film metal island regions in a silicon tetrachloride gas atmosphere at high temperatures to form columnar crystallites, thereby manufacturing a photonic crystal of a structure having the columnar crystallites arranged at periodic intervals. It is possible to obtain columnar crystallites whose surface roughness is as small as 10 nm or less in terms of the center-line average roughness Ra, for instance.

## Description

### BACKGROUND OF THE INVENTION

The present invention relates to a method of making a photonic crystal.

The photonic crystal is a man-made crystal of a structure in which two kinds of media significantly different in refractive index are systematically arranged at periodic intervals substantially equal to the light wavelength, and the photonic crystal is called a one-, two- or three-dimensional photonic crystal according to the number of dimensions in which the photonic crystal is periodic.

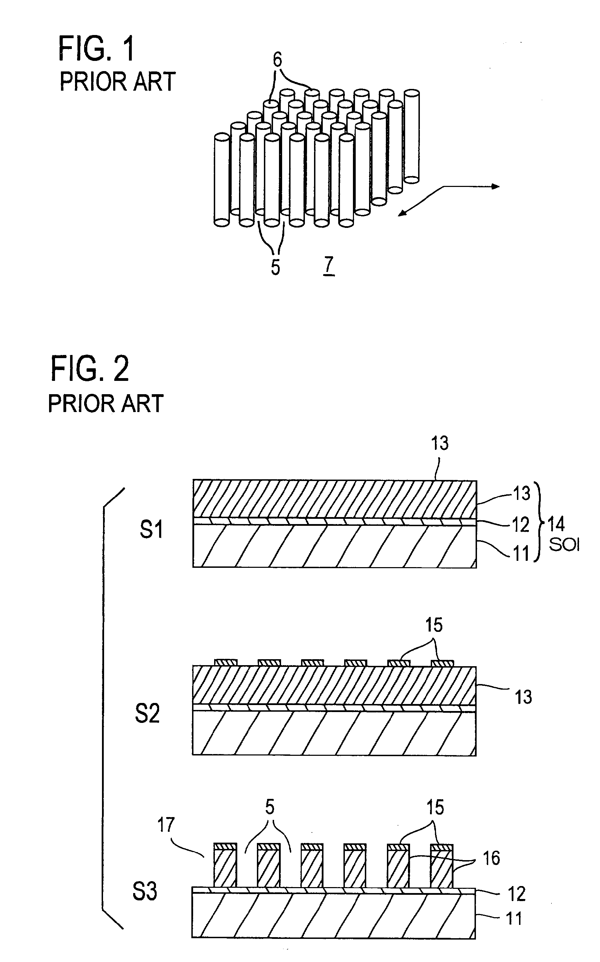

Fig. 1 schematically shows an example of the periodic structure of a two-dimensional photonic crystal 7, in which columnar crystallites (or crystalline rods) 6 are arranged at periodic intervals nearly equal to the light wavelength in a medium 5 of a refractive index different from that of the columnar crystallites 6. The arrows indicate the directions in which to open photonic band gaps (i.e. the directions in which no light travels). The medium 5 is a material filling gaps between the columnar crystallites 6; in Fig. 1 the medium is air.

Fig. 2 depicts a sequence of steps S1 to S3 involved in a prior art method of manufacturing a photonic crystal of such a structure as shown in Fig. 1. The conventional manufacturing method will be described below with reference to Fig. 2.

Step S1: Prepare an SOI (Silicon On Insulator) substrate 14 of a three-layered structure composed of a single-crystal silicon (Si) layer 11, a silicon dioxide layer 12 and a single-crystal silicon layer 13.

Step S2: Coat the one single-crystal silicon layer 13 over its entire surface area with a thin film of gold (Au) by evaporation or the like, and photoengrave the gold thin film (by photolithography and etching) to leave the desired pattern of circular island regions of gold 15 arranged at a predetermined pitch.

Step S3: Subject the single-crystal silicon layer 13 to anisotropic dry etching using the gold islands 15 as masks to form silicon monocrystalline rods 16.

In this way, a two-dimensional photonic crystal 17 composed of the silicon monocrystalline rods 16 and air 5 is formed on the silicon dioxide layer 12.

Incidentally, the problem attendant to the above-described conventional method using anisotropic silicon dry etching to form silicon monocrystalline rods in a predetermined pattern is the technical difficulty in controlling or reducing the roughness of the peripheral surface of each monocrystalline rod―this makes the fabrication of practicable photonic crystals a formidable task.

### SUMMARY OF THE INVENTION

It is therefore an object of the present invention to provide a photonic crystal manufacturing method which greatly improves the smoothness of the peripheral surface of each columnar crystallite ns hence permits easy fabrication of practicable photonic crystals.

The manufacturing method according to the present invention comprises the steps of: (a) forming a desired periodic pattern of thin-film metal island regions all over the surface of a (111) single-crystal silicon layer overlying a layer of a material different in refractive index from silicon; and (b) growing silicon monocrystalline rods beneath the thin-film metal island regions in a silicon tetrachloride gas atmosphere to form a two-dimensional photonic crystal having columnar crystallites arranged in a predetermined periodic pattern.

In the above, the step (b) may also be a step of forming the desired periodic pattern of thin-film metal island regions, then selectively etching away the (111) single-crystal silicon layer except the island regions, and growing the silicon monocrystalline rods. Alternatively, it is possible to form the pattern of island regions first, then grow the silicon monocrystalline rods, and selectively etch away the (111) single-crystal silicon layer except the island regions. In the above, gold, for instance, is used to form the thin-film metal island regions.

### BRIEF DESCRIPTION OF THE DRAWINGS

Fig. 1 is a schematic showing of an example of the periodic structure of a two-dimensional photonic crystal;
Fig. 2 is a sequence of steps involved in a prior art method of making the photonic crystal shown in Fig. 1;
Fig. 3 is a sequence of steps involved in the photonic crystal manufacturing method according to an embodiment of the present invention; and
Fig. 4 is a plan view showing an example of a pattern of thin-film metal (gold) island regions.

### DETAILED DESCRIPTION OF THE PREFERRED EMBODIMENT

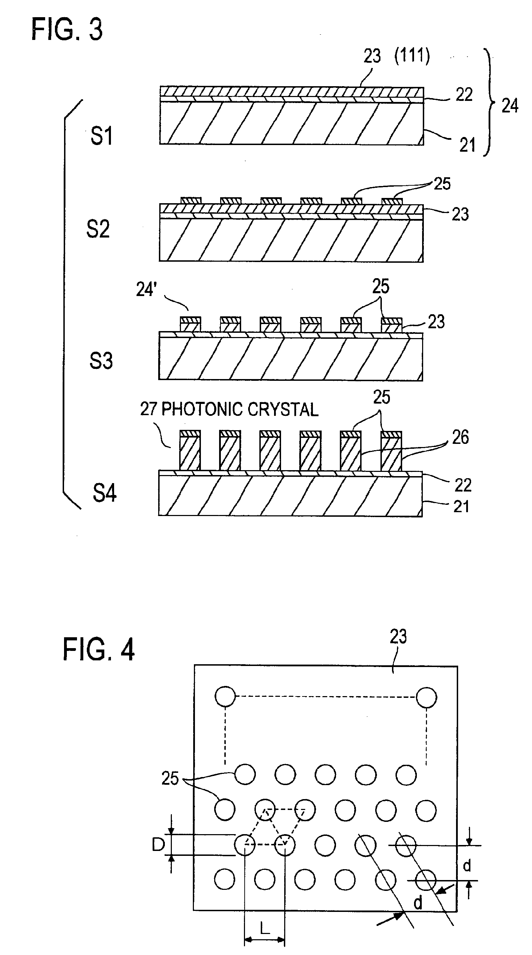

Fig. 3 illustrates a sequence of steps involved in the photonic crystal manufacturing method according to an embodiment of the present invention, which will be described below together with concrete examples of numerical values.

Step S 1: Prepare an SOI substrate 24 of a three-layer structure composed a 400-µm-thick single-crystal silicon layer 21, a 55-µm-thick silicon dioxide layer 22 and a 50-µm-thick (111) single-crystal silicon layer 23.

Step S2: Evaporate a gold (Au) film 0.2 µm thick onto the surface of a (111) single-crystal silicon layer 23 and photoengrave the gold film (by photolithography and etching) to leave a predetermined periodic pattern of gold island regions 25 having the desired shape and arranged at predetermined periodic intervals. In this example, as shown in Fig. 4, the gold island regions 25 are circular ones each having a 0.3-µm diameter D and formed at points of intersection of first parallel straight lines equally spaced apart by d and second parallel straight lines also equally spaced apart by d but forming an angle of 60° with respect to the first straight lines. The length L of each side of a regular triangle with vertexes at the centers of three adjacent circles is, for instance, 0.6 µm.

Step S3: Selectively etch away the (111) single-crystal silicon layer 23 except the gold island regions 25 by means of ICP (Inductive Coupled Plasma) etching, for instance.

Step S4: Place a substrate 24', obtained by step S3, in a silicon tetrachloride (SiCl₄) gas atmosphere held at 950°C to grow silicon monocrystals beneath the gold island regions 25 to form silicon monocrystalline rods 26. The silicon monocrystalline rods 26 are grown to a height of, for example, 200 µm or so.

By the above-described manufacturing steps, a structure having the silicon monocrystalline rods 26 arranged as desired is obtained, that is, a two-dimensional photonic crystal 27 composed of the silicon monocrystalline rods 26 and air is formed on the silicon dioxide layer 22.

The mechanism of the phenomenon in which silicon monocrystals, for example, whiskers, are grown beneath gold island regions in the (111) plane of silicon crystal in a silicon vapor growth atmosphere was reported by W. S. Wagner and W. C. Ellis (Applied Physics Letters, 4, 84 (1964)). Afterward, a method of growing silicon whiskers at low temperatures by use of gallium (Ga) instead of using gold was reported by S. Sharma et al. (Material Research Society Spring Meeting, April 17, 2001).

According to the method described above, the silicon monocrystalline rods 26 forming the columnar crystallites are formed by vapor phase epitaxy, not by the conventional anisotropic dry etching; this greatly improves the surface smoothness of the silicon monocrystalline rods.

More specifically, it is possible to obtain crystalline rods of surfaces (peripheral surfaces) having a center-line average roughness Ra of 10 nm or less. Accordingly, the above-described method of the present invention permits fabrication of practicable photonic crystals.

While the above embodiment has been described to use the SOI substrate 21 and form the silicon monocrystalline rods 26 on the silicon dioxide layer 22 of the SOI structure 21, the silicon dioxide layer 22 may be replaced with a layer of a different material, which has a refractive index different from that of silicon. Further, the thin-film gold island regions 25 may also be replaced with island regions of a different metal which forms a eutectic melt with silicon at high temperatures. In such an instance, the temperature for the vapor phase epitaxy of silicon varies with the metal used.

The above embodiment has been described to grow the silicon monocrystalline rods 26 after selectively etching away the (111) single-crystal silicon layer 23 except the gold island regions 25, but the order of these steps may also be reversed since the silicon monocrystalline rods 26 can be grown beneath the gold island regions 25 in the silicon vapor growth atmosphere prior to the selective etching-away of the single-crystal silicon layer 23. From the viewpoint of the configuration/position accuracy of the silicon monocrystalline rods 26, however, the selective etching-away of the (111) single-crystal silicon layer 23 may preferably be followed by the growth of the silicon monocrystalline rods 26 as depicted in Fig. 3.

### EFFECT OF THE INVENTION

As described above, the present invention enables the columnar crystallites of the photonic crystal to be formed by silicon monocrystalline rods of improved surface smoothness, and hence it permits fabrication of practicable photonic crystals.

## Claims

1. A method of making a two-dimensional photonic crystal of a structure having columnar crystallites arranged at periodic intervals, said method comprising the steps of:
(a) forming a periodic pattern of thin-film metal island regions all over the surface of a (111) single-crystal silicon layer overlying a layer of a material different in refractive index from silicon; and
(b) forming said columnar crystallites by growing silicon monocrystalline rods beneath said thin-film metal island regions of said periodic pattern in a silicon tetrachloride gas atmosphere.

2. The method of claim 1, wherein said step (b) includes the steps of:
selectively etching away said (111) single-crystal silicon layer except said thin-film metal island regions formed by said step (a); and
growing said silicon monocrystalline rods.

3. The method of claim 1, wherein said step (b) includes a step of selectively etching away said (111) single-crystal silicon layer except said thin-film metal island regions after said step of growing said silicon monocrystalline rods.

4. The method of any one of claims 1 to 3, wherein gold is used to form said metal thin-film island regions.
